# NEUE EUROPÄISCHE PATENTSCHRIFT

(11) **EP 0 694 507 B2**
(45) Veröffentlichungstag und Bekanntmachung des Hinweises auf die Entscheidung über den Einspruch: **07.01.2004**
(45) Hinweis auf die Patenterteilung: 24.02.1999
(21) Anmeldenummer: 95106780.0
(22) Anmeldetag: 05.05.1995
(51) Int. Cl.: C04B 35/457, C23C 14/34

(54) **Verfahren zur Herstellung eines Bauteils aus Indium-Zinn-Oxid**
Process for manufacturing an Indium-Tin-Oxide component.
Procédé pour la préparation d'un élément constitutif en oxyde d'indium et d'étain.

(30) Priorität: 29.07.1994 DE 4427060
(43) Veröffentlichungstag der Anmeldung: 31.01.1996
(73) Patentinhaber: W.C. Heraeus GmbH & Co. KG, 63450 Hanau (DE)
(72) Erfinder: Hörmann, Michael, Dr., D-63776 Mömbris (DE); Lupton, David Francis, Dr., D-63571 Gelnhausen (DE); Schielke, Jörg, D-63486 Bruchköbel (DE); Schölz, Friedhold, D-63517 Rodenbach (DE)
(74) Vertreter: Kühn, Hans-Christian

(56) Entgegenhaltungen:
- EP-A- 0 386 932
- EP-A1- 0 584 672
- DE-A1- 3 300 525
- DE-C1- 4 124 471
- DATABASE WPI Week 9404 Derwent Publications Ltd., London, GB; AN 94-32156 & JP-A-05 339 721 (MITSUBISHI MATERIALS CORP.) , 21.Dezember 1993
- PATENT ABSTRACTS OF JAPAN vol. 17 no. 577 (C-1122) ,20.Oktober 1993 & JP-A-05 170513 (TOSOH CORP.) 9.Juli 1993,
- PATENT ABSTRACTS OF JAPAN vol. 14 no. 322 (C-739) ,10.Juli 1990 & JP-A-02 115326 (MITUBISHI METAL CORP.) 27.April 1990,
- ENOKI et al, J. Mat. Sci., 26 (1991), Seiten 4110-4115
- B.G.LEWIS, "Structure and Performance of ITO Sputtering Targets", Society of Vacuum Coaters, 37th Annual Technical Conf.Proc. 1994

## Beschreibung

Die vorliegende Erfindung betrifft ein Verfahren zur Herstellung von Bauteilen aus Indium-Zinn-Oxid durch Formen eines Rohlings aus einem eine Mischkristallphase aus Indium-Oxid und Zinn-Oxid enthaltenden Mischkirstallpulvers und Sintern des Rohlings.

Derartige Indium-Zinn-Oxid-Bauteile werden beispielsweise als sogenannte "ITO-Sputtertargets" für die Herstellung dünner Schichten aus Indium-Zinn-Oxid eingesetzt. Diese Schichten zeichnen sich durch ihre Transparenz im Wellenlängenspektrum des sichtbaren Lichtes und durch ihre elektrische Leitfähigkeit aus. Wegen dieser Eigenschaften finden sie beispielsweise Verwendung für die Herstellung von Flüssigkristallanzeigen. Am besten bewährt hat sich eine Zusammensetzung mit 90 Gew.-% Indiumoxid und 10 Gew.-% Zinnoxid.

Für die Qualität der Sputtertargets sind neben ihrer Homogenität, Reinheit und ihres Oxidationsgrades insbesondere auch Dichte und Mikrostruktur von Bedeutung. Es hat sich herausgestellt, daß für die Erzeugung gleichmäßiger dünner Schichten eine hohe Dichte des Sputtertargets vorteilhaft ist. Aus der europäischen Patentanmeldung EP-A1 0 584 672 sind Indium-Zinn-Sputtertargets mit Dichten bis zu 99 % der jeweils theoretischen Dichte bekannt. Bei den bekannten Sputtertargets weisen die gesinterten Oxidpartikel eine Größe zwischen 1 µm und 20 µm auf. Es hat sich herausgestellt, daß bei gröberem Korn das Sputtertarget spröde wird und daß bei feinerem Korn die erreichbare Sputtergeschwindigkeit gering ist. Zur Herstellung der Indium-Zinn-Sputtertargets wird vorgeschlagen, Indium-Oxid-Pulver und Zinn-Oxid-Pulver miteinander zu mischen, aus dem Pulvergemisch den Rohling zu formen, diesen, gegebenenfalls durch kaltisostatisches Pressen, zu verdichten und anschließend bei Temperaturen zwischen 1280 °C und 1600 °C während einer Haltezeit von 5 Stunden unter sauerstoffhaltiger Atmosphäre zu sintern. Das verwendete Indiumoxid-Pulver wird durch Fällung in einem wässrigem Medium erzeugt. Es liegt sehr feinteilig vor und weist eine BET-Oberfläche über 15 m²/g auf. Mit diesem feinkörnigen Ausgangspulver kann eine homogene Verteilung der oxidischen Komponenten erreicht werden. Die so hergestellten ITO-Sputtertargets zeichnen sich durch eine hohe Dichte und eine gute Lichtdurchlässigkeit der damit hergestellten, dünnen Schichten aus. Sie sind jedoch aufwendig herzustellen und bruchanfällig.

Ein weiteres Verfahren ist in dem von der Firma Arconium Specialty Alloys, Providence, RI 02909 zur Verteilung gelangten Aufsatz "Structure and Performance of ITO Sputtering Targets" von B. E. Lewis et al. beschrieben. Zur Erzielung hoher Dichten und einer besonders hohen elektrischen Leitfähigkeit wird vorgeschlagen, die Pulver aus den Oxiden von Zinn und Indium miteinander zu vermischen, aus dem Kristallpulvergemisch den Rohling zu formen und diesen bei Temperaturen oberhalb von etwa 1200 °C unter Normaldruck zu sintern. Das so erhaltene ITO-Sputtertarget besteht aus einem Mischkristall mit weitgehend einphasigem Kristallgefüge. Die wissenschaftliche Grundlage für diese Verfahrensweise ergibt sich aus dem Zustandsdiagramm von Indium-Oxid und Zinn-Oxid, wie es beispielsweise von Enoki et al. in Journal of Materials Sciences 26 (1991), Seite 4110 bis 4115, veröffentlicht worden ist. Danach kann bei einem Kristallgemisch von 90 Gew.-% Indium-Oxid und 10 Gew.-% Zinn-Oxid durch Erhitzen auf ca. 1500 K die vollständige Löslichkeit von Zinn-Oxid in Indium-Oxid und damit eine vollständige Mischkristallbildung erreicht werden.

In der Veröffentlichung von B. G. Lewis et. al. sind auch Verfahrensweisen beschrieben, bei denen Pulvergemische aus den beiden Oxiden, die einen geringen Anteil an Indium-Metall enthalten, in einer Form verdichtet und unter Druck erhitzt werden. Es hat sich gezeigt, daß nach diesen Verfahren hergestellte ITD-Sputtertargets einzelne Partikel aus Zinn-Oxid enthalten, die die elektrische Leitfähigkeit des Targets zum Nachteil der Sputterrate reduzieren..

Mittels den bekannten Verfahren ist es möglich, Bauteile aus Indium-Zinn-Oxid mit hoher Dichte herzustellen. Problematisch ist aber die Herstellung einer homogenen Mischung aus den Oxiden, was die Verwendung spezieller Indiumoxid- und Zinnoxidqualitäten, sowie aufwendige Mischverfahren erfordert. Die hohen Sintertemperaturen, verbunden mit langen Haltezeiten, erfordern außerdem einen hohen Energieaufwand für die Herstellung der Bauteile.

Ein gattungsgemäßes Verfahren zur Herstellung von Sputtertargets ist aus dem Abstract zur japanischen Patentanmeldung JP 2-115326 A bekannt [veröffentlicht in Patents Abstracts of Japan, Sect. C, Vol. 14 (1990), Nr. 322 (C-739)]. Bei dem darin beschriebenen Verfahren wird metallisches Zinnpulver mit Indiumoxidpulver gemischt und in reduzierender, nicht oxidierender Atmosphäre kalziniert Der so hergestellte Indium-Zinn-Oxid-Mischkristall wird gemahlen und in nicht oxidierender Atmosphäre zu einem Block heißgepreßt, aus dem anschließend Sputtertargets gefertigt werden.

Aus dem Abstract zur japanischen Patentanmeldung JP-A-5339721 (veröffentlicht in Patent Abstracts of Japan PAJ/JPO abstract vol. 018185/94-03-30) ist weiterhin ein Verfahren bekannt, beim dem ein Mischkristallpulver aus Indium-Zinn-Oxid einer Wärmebehandlung bei 650°C bis 1100°C unter Vakuum unterzogen wird. Anschließend erfolgt eine "Ausgleichsabkühlung" (transiently cooling) auf eine Temperatur unterhalb 500°C. Bei einer derartigen Behandlung ergeben sich Zinnoxidausscheidung, die den Anteil an Mischkristallphase deutlich verringern. Das so vorbehandelte Pulver mit einem verringerten Mischkristall-Anteil wird anschließend unter Vakuum heißgepreßt, so daß ein Formkörper entsteht, aus dem Sputtertargets mit hohen Sputterraten hergestellt werden.

Aus EP 584 672 ist ein Bauteil aus Indium-Zinn-Oxid bekannt, mit einer mittleren Komgröße der gesinterten Oxidpartikel von mehr als 2 µm und mit einer Dichte von mehr als 95 % seiner theoretischen Dichte. Die Oxidpartikel liegen mit einem sehr hohen Gewichtsanteil als Mischkristall im Kristallgitter von Indium-Oxid vor. Es ist beschrieben, dass nicht gelöstes Zinn-Oxid in einem Anteil von 1 bis 5 % vorliegt.

Der vorliegenden Erfindung liegt die Aufgabe zugrunde, ein besonders wirtschaftliches Verfahren für die Herstellung von Bauteilen aus Indium-Zinn-Oxid mit hoher spezifischer Dichte und mit homogenem Kristallgefüge bereitzustellen.

Dadurch, daß die Oxidpartikel als Mischkristall vorliegen, wird eine besonders homogene Verteilung von Indium und Zinn gewährleistet. Dies erleichtert die Herstellung gleichmäßiger, homogener ITO-Schichten aus dem Bauteil. Weiterhin fördert das homogene, im wesentlichen einphasige Kristallgefüge im Kristallgitter von Indiumoxid die Bruchfestigkeit des Bauteils. Zudem ermöglicht die einphasige Mischkristallstruktur die Herstellung von ITO-Schichten mit einer hohen elektrischen Leitfähigkeit. Diese günstigen Effekte wirken sich umso stärker aus, je höher der Anteil an Mischkristallphase im Bauteil ist. Die Effekte wurden aber erst ab einem Mindestanteil von 97 Gew.-% beobachtet.

Als besonders günstig hat sich ein Bauteil erwiesen, bei dem die mittlere Korngröße der gesinterten Oxidpartiket weniger als 20 µm beträgt. Dies wirkt sich insbesondere hinsichtlich der Festigkeit des Bauteils positiv aus. Dabei wird eine Ausführungsform des Bauteils bevorzugt, bei der der Mischkristall in der Gitterstruktur des Indiumoxids vorliegt.

Es wird die oben genannte Aufgabe ausgehend von den bekannten Verfahren erfindungsgemäß dadurch gelöst, daß das Sintem beim Temperaturen unterhalb von 1100° C, vorzugsweise bei Temperaturen zwischen 800° C und 1050° C erfolgt. Es wurde festgestellt, daß eine geeignete Mischkristallphase im Röntgen-Pulverdiffraktometer einen Beugungswinkel von 28 bei etwa 30,5 ° erzeugt. Hierbei kann es sich um die Indium-Oxid-Kristallphase handeln, wobei in die Kristallstruktur Zinn-Oxid eingebaut ist. Es ist anzunehmen, daß dabei Indiumionen auf Indium-Gitterplätzen durch Zinnionen substituiert sind. Bevorzugt wird ein Mischkristallpulver, das im wesentlichen aus der Mischkristallphase besteht. Dadurch, daß bei dem erfindungsgemäßen Verfahren nicht von einem Kristallpulvergemisch, sondern überwiegend oder ausschließlich von Mischkristallpulver mit einer einzigen Mischkristallphase ausgegangen wird, ist es nicht erforderlich die Sintertemperatur auf über 1200 °C einzustellen, um die Mischkristallphase zu erzielen. Die Sintertemperatur kann wesentlich niedriger gehalten werden. Dadurch ist das erfindungsgemäße Verfahren hinsichtlich des Energieaufwandes wirtschaftlicher als die bekannten Verfahren. Es hat sich aber auch gezeigt, daß zum Teil höhere Dichten als nach den bekannten Verfahren erzielt werden.

Bei Sintertemperaturen oberhalb 1100° C besteht die Gefahr, daß sich Zinn-Oxid aus der Mischkristallphase wieder ausscheidet Andererseits ist es für die Erzielung hoher Dichten günstig, bei möglichst hohen Temperaturen zu sintern. Als günstig hinsichtlich einer hohen Dichte des herzustellenden ITO-Bauteils einerseits und einer möglichst geringen Ausscheidung von Zinn-Oxid aus dem Mischkristall andererseits hat es sich erwiesen, bei einer Temperatur unterhalb von 1050 °C und oberhalb von 800 °C zu sintern. Diese Sintertemperaturen sind relativ niedrig. Sie ermöglichen eine wirtschaftliche Verfahrensweise. Soweit das Sintern unter Bedingungen erfolgt, bei denen die Einstellung des chemischen Gleichgewichts langsam erfolgt, im Vergleich zur Sinterdauer, können niedrigere Sintertemperaturen durch längere Sinterzeiten ausgeglichen werden und umgekehrt. Die angegebenen Sintertemperaturen sind insofern nur als Richtwerte anzusehen, da gleiche Sinterergebnisse auch beispielsweise bei niedrigeren Sintertemperaturen, aber entsprechend längeren Sinterzeiten erzielbar sind.

Besonders bewährt hat es sich, das Mischkristallpulver beim Sintern zu pressen. Dadurch wird die erwünschte hohe Dichte des Bauteils in wirtschaftlich vertretbaren Zeiten erreicht, ohne hohe Sintertemperaturen und damit die Gefahr von Ausscheidungen von Zinnoxid aus dem Mischkristallgefüge in Kauf nehmen zu müssen.

Als besonders vorteilhaft hat es sich jedoch erwiesen, das Mischkristallpulver beim Sintern heißisostatisch zu pressen. Dadurch wird eine gleichmäßige Verdichtung des Mischkristallpulvers im Rohling und eine gleichmäßige Dichteverteilung im gesinterten Bauteil erreicht. Bewährt haben sich Drücke im Bereich von 50 MPa bis 150 MPa, wobei sich Haltezeiten bei der Sintertemperatur im Bereich von 2 h bis 6 h als geeignet erwiesen haben.

Für die Herstellung von ITO-Sputtertargets werden Korngrößenverteilungen des Mischkristallpulvers verwendet, die eine BET-Oberfläche von weniger als 5 m²/g, vorzugsweise von weniger als 1 m²/g erzeugen. Es wurde festgestellt, daß mittlere Korngrößen im Bereich von 1 µm bis 20 µm zu der gewünschten BET-Oberfläche der Mischkristallpulvers führen. Bei größeren Korngrößen besteht die Gefahr der Versprödung des daraus hergestellten Bauteils, bei kleineren Körnern hat es sich gezeigt, daß bei Verwendung derartiger Bauteile als ITO-Sputtertargets die Sputtergeschwindigkeit gering ist.

Ausführungsbeispiele der Erfindung werden nachfolgend anhand von Zeichnungen näher erläutert. In der Zeichnung zeigen im einzelnen:
- **Figur 1**: ein Beugungswinkel-Diagramm einer pulverröntgendiffraktometrischen Aufnahme von Indiumoxid-Pulver und die dazugehörigen Literaturwerte
- **Figur 2**: ein Beugungswinkel-Diagramm einer pulverröntgendiffraktometrischen Aufnahme von Zinnoxid-Pulver und die dazugehörigen Literaturwerte
- **Figur3**: ein Beugungswinkel-Diagramm einer pulverröntgendiffraktometrischen Aufnahme eines zur Herstellung des erfindungsgemäßen Bauteils verwendeten Mischkristallpulvers
- **Figur 4**: Beugungswinkel-Diagramme röntgendiffraktometrischer Aufnahmen von erfindungsgemäß hergestellten Bauteilen nach dem Sintern bei unterschiedlichen Temperaturen.

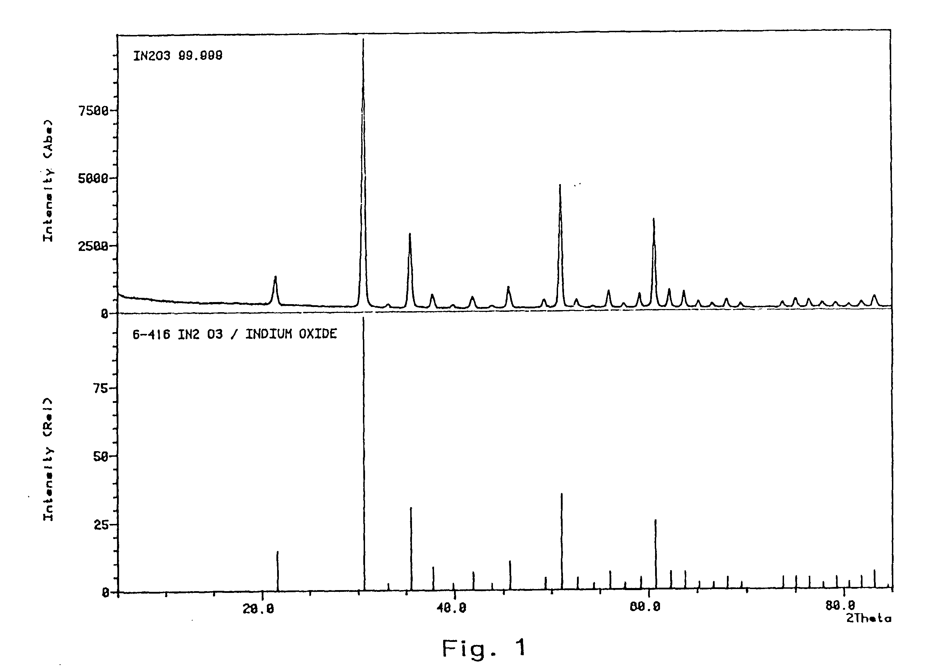

Aus dem Beugungsdiagramm der Figur 1 ist ersichtlich, daß bei Indiumoxid der Hauptbeugungswinkel 2θ bei etwa 30,5 Grad liegt. Nebenmaxima sind bei Beugungswinkeln 2θ von etwa 21,5 °, 35,5 °, 51 ° und 61 ° zu finden.

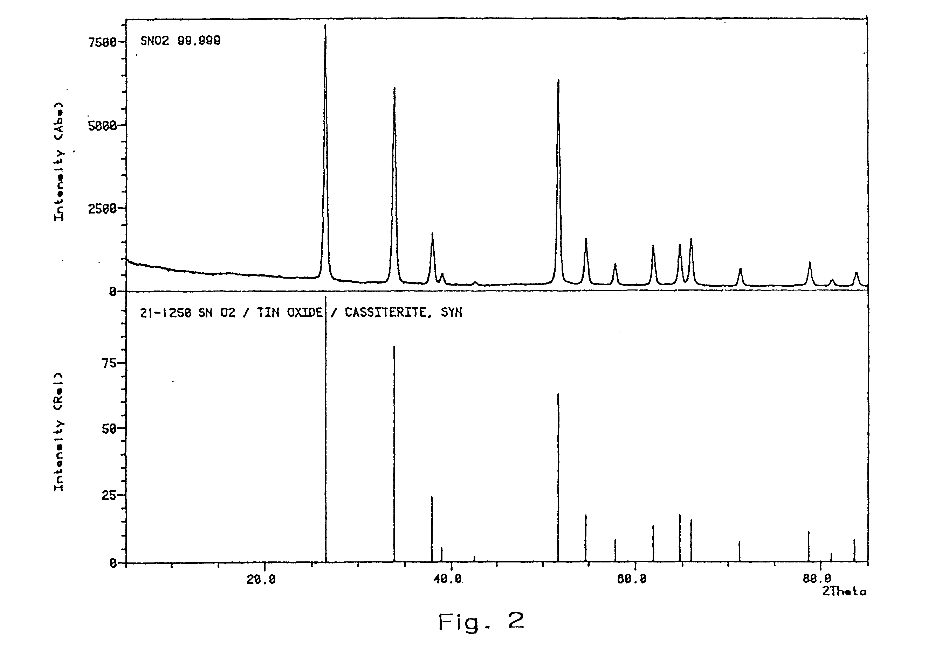

Die intensitätsstärksten Beugungswinkel 2θ bei Zinnoxid liegen bei 26 °, 34 ° und bei 52 °, wie dies in Figur 2 gezeigt ist.

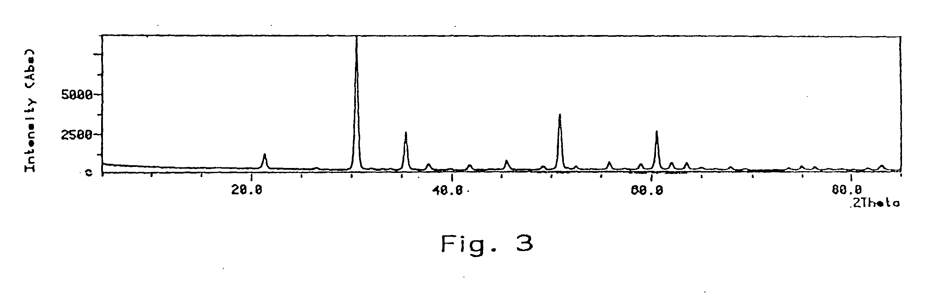

Das Beugungsdiagramm gemäß Figur 3 wurde an einem Mischkristallpulver mit einer Zusammensetzung von 90 Gew.-% Indiumoxid und 10 Gew.-% Zinnoxid aufgenommen. Die mittlere Korngröße des Pulvers lag bei etwa 3 µm; seine spezifische BET-Oberfläche bei 0,3 m²/g. Das Beugungsdiagramm zeigt fünf deutliche Intensitäts-Peaks. Das Maximum liegt bei 30,5 °, das entspricht dem Hauptbeugungswinkel des Indiumoxidpulvers. Außerdem sind kleinere Peaks bei 21,5 °, 35,5 °, 51 ° und bei 61 °, entsprechend dem Beugungsdiagramm von Indiumoxid, zu erkennen.

Eine kleine Intensitätsspitze taucht bei einem Beugungswinkel 2θ von etwa 26 ° auf. Dies entspricht dem Hauptbeugungswinkel von Zinnoxid. Die gemessene Intensität ist aber wensentlich niedriger, als es aufgrund des gewichtsmäßigen Anteils von Zinnoxid in einem Oxidgemisch zu erwarten wäre. Die Höhe des Intensitäts-Peaks läßt vielmehr für die Zinnoxid-Phase auf einen Gewichtsanteil von ca. 2 % schließen. Das Mischkristallpulver ist somit im wesentlichen einphasig.

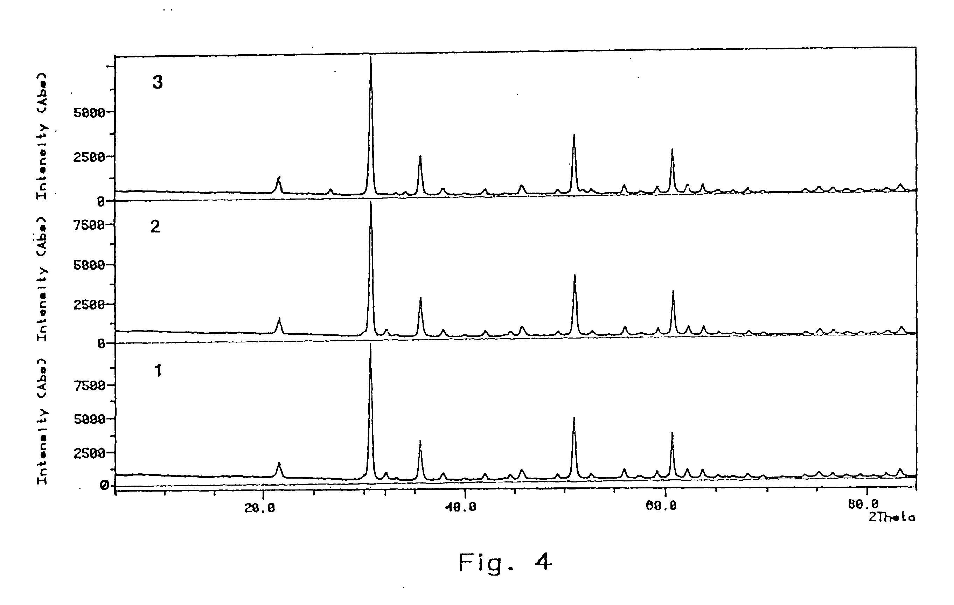

Aus einem weiteren Mischkristallpulver, das ebenfalls eine Zusammensetzung von 90 Gew.-% Indiumoxid und 10 Gew.-% Zinnoxid besteht, das aber nur eine einzige oxidische Mischphase aufweist wurden durch heißisostatisches Pressen drei Bauteil-Proben hergestellt. Hierzu wurden die Pulver in einer Stahlhülle gekapselt und bei 100 MPa über eine Haltezeit von drei Stunden gesintert. Die Sintertemperatur wurde dabei von Probe 1 bis Probe 3 variiert; die übrigen Prozeßparameter waren bei allen Proben gleich. Die Sintertemperatur betrug bei Probe 1: 870°C, bei Probe 2: 970°C und bei Probe 3: 1070°C. In der Fig. 4 sind die jeweiligen Beugungsdiagramme mit den Probennummern 1, 2 und 3 bezeichnet. Die Beugungsintensitätsverläufe der Proben 1 und 2 unterscheiden sich demnach kaum. Sie entsprechen im wesentlichen demjenigen des eingesetzten Mischkristallpulvers und demjenigen, das für Indiumoxid gemäß Figur 1 gemessen worden ist. Lediglich bei einem Beugungswinkel von etwa 32,1 ° ist ein kleines zusätzliches Intensitätsmaximum zu erkennen, das aber weder Indiumoxid noch Zinnoxid zugeordnet werden kann.

Erst bei der Probe 3, die bei einer Temperatur von 1070°C gesintert worden ist, ändert sich der Intensitätsverlauf des Beugungsdiagramms. Hier taucht eine kleine Intensitätsspitze bei etwa 26 ° auf, die eine Zinnoxidkristallphase anzeigt. Diese zweite Kristallphase sollte möglichst vermieden werden. Die spezifischen Dichten der Proben 1, 2 und 3 ergeben sich aus der folgenden Tabelle:

| Probennummer | Dichte in g/ccm |
|---|---|
| 1 | 7,03 |
| 2 | 7,06 |
| 3 | 7,08 |

Die theoretische Dichte liegt bei ca. 7,14 g/ccm. Die gemessenen Dichten liegen daher sämtlich um 99 % der theoretischen Diche. Da die Dichte der Probe 3 nicht wesentlich über denjenigen der Proben 1 und 2 liegt, jedoch andererseits bereits Zinnoxid als zweite Phase beim Sintern ausgeschieden ist, ergeben sich zusammen mit den übrigen Prozeßparametern für diesen Fall optimale Sintertemperaturen von unterhalb 1070°C.

Es können jedoch auch höhere Sintertemperaturen gewählt werden, ohne daß sich die Zinnoxid-Kristallphase ausscheidet, wenn die Sinterzeiten verkürzt werden, was bei den höheren Sintertemperaturen wegen der beschleunigten Sintervorgänge möglich ist, ohne geringere Dichten in Kauf nehmen zu müssen.

## Patentansprüche

1. Verfahren zur Herstellung von Bauteilen aus Indium-Zinn-Oxid, mit einer mittleren Korngröße der gesinterten Oxidpartikel von mehr als 2 µm, und mit einer Dichte von mehr als 95 % ihrer theoretischen Dichte, wobei die Oxidpartikel mit einem Gewichtsanteil von mindestens 97 % als Mischkristall im Kristallgitter von Indium-Oxid vorliegen, durch Formen eines Rohlings aus einem eine Mischkristallphase aus Indium-Oxid und Zinn-Oxid enthaltenden Mischkristallpulvers, und Sintern des Rohlings, **dadurch gekennzeichnet, daß** das Sintern bei Temperaturen unterhalb von 1100 °C, vorzugsweise bei Temperaturen zwischen 800 °C und 1050 °C erfolgt und daß das Mischkristallpulver eine BET-Oberfläche von weniger als 5 m²/g aufweist.

2. Verfahren nach Anspruch 1, **dadurch gekennzeichnet, daß** das Mischkristallpulver beim Sintern heißgepreßt wird.

3. Verfahren nach Anspruch 1 oder 2, **dadurch gekennzeichnet, daß** das Mischkristallpulver heißisostatisch gepreßt wird.

4. Verfahren nach Anspruch 1, **dadurch gekennzeichnet, daß** das Mischkristallpulver eine BET-Oberfläche von weniger als 1 m²/g aufweist.

## Claims

1. Process for the production of components from indium tin oxide, having a mean particle size of the sintered oxide particles of more than 2 µm, and having a density of more than 95% of their theoretical density, the oxide particles being present in an amount by weight of at least 97% as a solid solution in the crystal lattice of indium oxide, by forming a blank from a solid solution phase of solid solution powder containing indium oxide and tin oxide, and sintering the blank, **characterized in that** the sintering is effected at temperatures below 1100°C, preferably at temperatures between 800°C and 1050°C, and that the solid solution powder has a BET surface area of less than 5 m²/g.

2. Process according to Claim 1, **characterized in that** the solid solution powder is hot-pressed during sintering.

3. Process according to Claim 1 or 2, **characterized in that** the solid solution powder is subjected to hot isostatic pressing.

4. Process according to Claim 1, **characterized in that** the solid solution powder has a BET surface area of less than 1 m²/g.

## Revendications

1. Procédé de préparation d'éléments en oxyde d'indium et d'étain ayant une taille de grains moyenne des particules d'oxyde frittées de plus de 2 µm, et une densité supérieure à 95 % de sa densité théorique, les particules d'oxyde se trouvant en une proportion d'au moins 97 % en masse sous forme de cristaux mixtes dans le réseau cristallin de l'oxyde d'indium, par moulage d'une ébauche à partir d'une poudre cristalline mixte contenant une phase cristalline mixte obtenue à partir d'oxyde d'indium et d'oxyde d'étain, et frittage de l'ébauche, **caractérisé en ce que** le frittage s'effectue à des températures inférieures à 1100°C, de préférence à des températures comprises entre 800°C et 1050°C, et **en ce que** la poudre cristalline mixte a une surface BET inférieure à 5 m²/g.

2. Procédé selon la revendication 1, **caractérisé en ce que** la poudre cristalline mixte est comprimée à chaud lors du frittage.

3. Procédé selon la revendication 1 ou 2, **caractérisé en ce que** la poudre cristalline mixte subit une compression isostatique à chaud.

4. Procédé selon la revendication 1, **caractérisé en ce que** la poudre cristalline mixte a une surface BET inférieure à 1 m²/g.
